# EUROPEAN PATENT APPLICATION

(11) **EP 1 670 299 A2**
(43) Date of publication of application: **14.06.2006**
(21) Application number: 05025697.3
(22) Date of filing: 24.11.2005
(51) Int. Cl.: H05K 3/34

(54) **Electronic component**

(30) Priority: 30.11.2004 JP 2004347102
(71) Applicant: DENSO CORPORATION, Kariya-city, Aichi-pref., 448-8661 (JP)
(72) Inventor: Oonishi, Jun, Kariya-city Aichi-pref., 448-8661 (JP)
(74) Representative: Kuhnen & Wacker

(57) **Abstract**

A surface-mounted electronic component (10) has an outer lead (12) extending from a package (11) for connection to a circuit pattern (21) on a printed circuit board (20) by using a connecting member (30). The outer lead (12) has a hole (12b) having an opening at least on a connecting member (30) facing side in a portion (12a) of the outer lead (12) for connecting the outer lead (12) to the circuit pattern (21).

## Description

The present invention generally relates to a surface-mounted electronic component having an outer lead for connection to a circuit pattern.

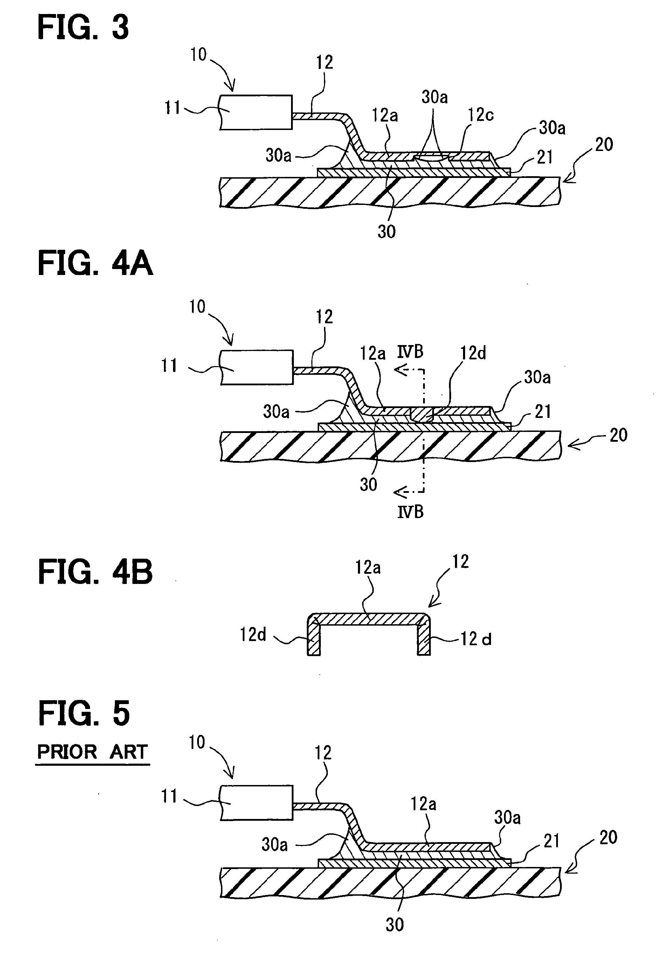

FIG. 5 shows a cross-sectional view of a surface-mounted electronic component 10 (e.g., a quad flat package) disposed on a printed circuit board 20.

In this structure of connection, the electronic component 10 having an outer lead 12 that protrudes from a package 11 is electrically and mechanically connected to a circuit pattern 21 (a pad as an electrode) on the printed circuit board 20 with a solder 30 by a thermocompression bonding.

Conventionally, the connection structure of the electronic component 10 and the printed circuit board 20 uses the solder 30. That is, for example, a thermocompression bonding tool is pressed against an upper surface of the outer lead 12 for melting the solder 30, and the outer lead 12 and the circuit pattern 21 are connected by the solder 30.

Therefore, only a vertical part and a side face of a bent portion 12a of the outer lead 12 are covered by a fillet 30a. That is, an upper surface (i.e., an opposite side to a circuit pattern 21 facing side) of the outer lead 12 (bent portion 12a) is hardly covered by the fillet 30a. In this case, connection between the outer lead 12 and the circuit pattern 21 will suffer from poor conductivity when the fillet 30a formed on the vertical part and the side face of the bent portion 12a is not sufficiently strong to bear an exfoliating force caused by vibration, temperature change or the like.

In view of the above-described and other problems, the present invention provides an electronic component that improves connection reliability.

In order to achieve an above-described object of the invention, the present invention describes a device of a surface-mounted electronic component having an outer lead protruding from an outer periphery of a package for connection to a circuit pattern on a printed circuit board with a connecting member.

The outer lead is characterized by a hole having an opening on a side that at least contacts the connecting member in a circuit pattern connecting portion.

In this manner, an additional fillet is formed on an internal circumference of the hole in the circuit pattern connecting portion besides the fillet described above. Therefore, reliability of the connection between the outer lead and the circuit pattern is improved.

For example, the outer lead may have the hole in the bent portion of the outer lead when the connecting portion of the outer lead is positioned as a portion that is bent to be substantially parallel to the circuit pattern.

The hole may be a non-piercing ditch on a surface of the outer lead. The hole is preferably a piercing hole, as described in claim 3, in the outer lead. The internal circumference of the piercing hole is easily covered with the connecting member because the air or the like in the hole can be released toward an opening on the opposite side of the outer lead when the connecting member is introduced in the hole.

In this case, the connecting member may be touching a periphery of the hole on the opposite side to the circuit pattern connecting side of the outer lead,. In this manner, the outer lead is sandwiched by the connecting member that fills the hole in the outer lead to have an improved reliability for connection.

The outer lead may be characterized by a projection on its surface instead of having the hole. The projection on the outer lead helps to keep a space between the outer lead and the circuit pattern when the outer lead is connected to the circuit pattern with the connecting member.

In this manner, the space between the outer lead and the circuit pattern has a fixed distance owing to the projection on the outer lead. Therefore, variation of the thickness of the connecting member and/or the height of the fillet is decreased. As a result, the connection between the outer lead and the circuit pattern becomes more reliable.

In this case, the outer lead may have the projection in the bent portion of the outer lead when the connecting portion of the outer lead is positioned as a portion that is bent to be substantially parallel to the circuit pattern.

The present invention the solder may be used as the connecting member.

Other objects, features and advantages of the present invention will become more apparent from the following detailed description made with reference to the accompanying drawings, in which:
FIG. 1A shows a top view of a connection structure of an electronic component in a first embodiment of the present invention;
FIG. 1B shows a cross-sectional view of the connecting structure taken along the IB - IB line in FIG. 1A;
FIG. 2 shows a cross-sectional view of a modification of the first embodiment;
FIG. 3 shows a cross-sectional view of another modification of the first embodiment;
FIG. 4A shows a cross-sectional view of the connecting structure of the electronic component in a second embodiment of the present invention;
FIG. 4B shows a cross-sectional view of the outer lead of the electronic component taken along the IVB - IVB line in FIG. 4A; and
FIG. 5 shows a cross-sectional view of the connecting structure of a conventional electronic component.

The present invention is described with reference to the drawings. The present invention is characterized by an outer lead of an electronic component, and the drawings in the following mainly describes the connection structure between the electronic component and the printed circuit board for the explanation of the characteristics and the effect of the invention.

### (First embodiment)

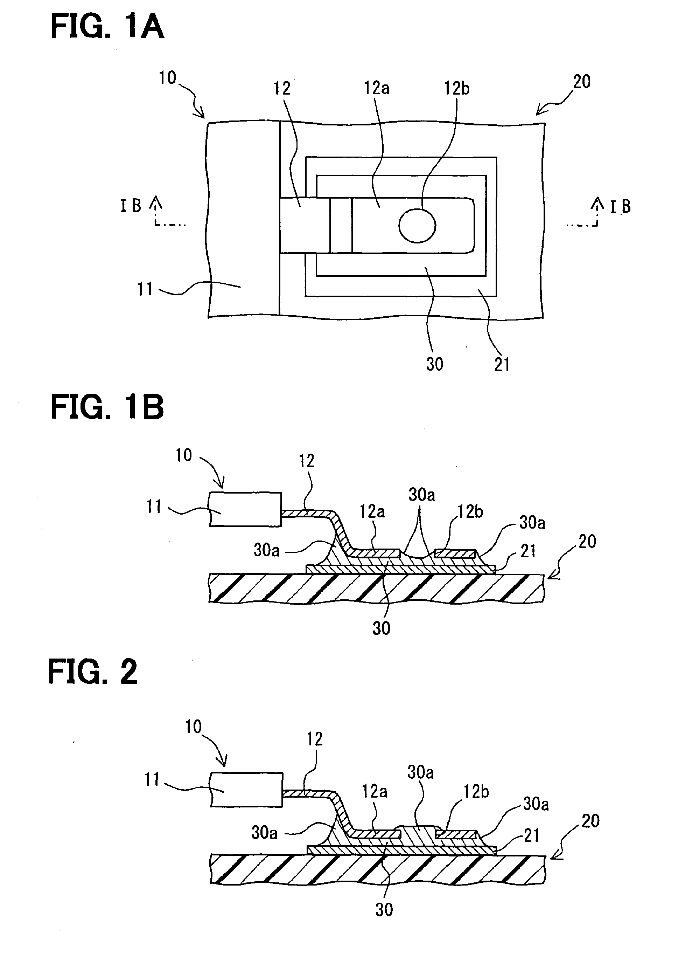

FIGS. 1 A and 1B show a connection structure of an electronic component in a first embodiment of the present invention. That is, FIG. 1A is a top view of the electronic component, and FIG. 1 B is a cross-sectional view of the electronic component taken along a IB - IB line in FIG. 1A.

As shown in FIGS. 1A and 1B, the electronic component 10 has a plurality of outer leads 12 extending outward from a package 11 that includes a semiconductor element. FIGS. 1 A and 1B show a part of the package.

The outer lead 12 has a bent portion 12a for a connecting part to a circuit pattern 21 formed as an electrode on a surface of a printed circuit board 20. The bent portion 12a of the outer lead 12 is substantially parallel with the circuit pattern 21. The bent portion 12a has a through hole 12b that piercingly connects a lower side (a circuit pattern facing side) of the bent portion 12a and an upper side (an opposite side of the circuit pattern facing side). The shape of the outer lead 12 is not necessarily limited to the shape described above.

The hole 12b has a substantially circular cross section, and is capable of having a solder as a connecting member introduced therein. The hole 12b is formed by using a well-known technology (e.g., a mechanical processing or a chemical processing). The shape of the cross section is not necessarily limited to the substantially circular. The cross section of the hole 12b may be in a rectangular shape. The number of the hole 12b may be more that one on each of the outer lead 12. The position of the hole 12b may be different from the place shown in FIGS. 1A and 1B as long as the hole 12b is in the bent portion 12a.

Next, the connection structure of the electronic component 10 is described with reference to FIG. 1B.

The outer lead 12 extending from the package 11 of the electronic component 10 is bended in a predetermined shape to have the bent portion 12a that is substantially parallel with the circuit pattern 21 in a connected condition. That is, the outer lead 12 and the circuit pattern 21 contact with each other in a face. The circuit pattern 21 on the printed circuit board 20 has the solder 30 as the connecting member pasted thereon by, for example, a screen printing in a portion that receives the bent portion 12a of the outer lead 12.

The outer lead 12 and the circuit pattern 21 are connected with the solder 30 that is melted by abutting a press-heating tool (not shown in the figure) to the upper side of the outer lead 12 after positioning the bent portion 12a of the outer lead 12 on the solder 30.

The bent portion 12a of the outer lead 12 in the electronic component 10 has a through hole 12b. Therefore, fillets 30a (a rise of the solder 30) are formed not only on a vertical portion of the bent portion 12a and a side face in the connecting portion of the outer lead 12 but also on an internal circumference of the through hole 12b because of the surface tension or the like of the solder 30 while the solder 30 is melting.

In this manner, the fillets 30a are formed on the internal circumference of the through hole 12b in the bent portion 12a of the outer lead 12 in the present embodiment besides the positions that was conventionally covered by the fillets 30a. Therefore, the reliability of the connection is improved because the connection is supported by a plurality of connecting points and the area of the connection between the outer lead 12 and the solder 30 is increased.

The structure of the printed circuit board 20 is not limited. In the present embodiment, a thermo-plastic resin board is used to have the circuit pattern 21 placed thereon. In addition, the rest of the circuit pattern and other portion such as a VIA connection are omitted in FIGS. 1 A and 1B.

In the present embodiment, the fillet 30a is formed on the internal circumference of the through hole 12b in the bent portion as shown in FIG. 1B. However, the solder 30 may fillingly pierce the through hole 12b and contact a periphery on the upper side of the through hole 12b as shown in FIG. 2. In this case, the solder 30 having the connecting portion in the through hole 12b binds the bent portion 12a of the outer lead 12 from both sides. Therefore, the reliability of the connection is improved. The fillets 30a shown as a cross section in FIG. 2 is a modification of the present embodiment that corresponds to the in FIG. 1 B.

The present embodiment shows the through hole 12b formed as an opening in the bent portion for connection and the fillet 30a formed on the internal circumference of the though hole 12b. However, a ditch 12c that does not pierce the outer lead 12 may be formed as an opening as shown in FIG. 3. In this case, the fillet 30a can also be formed on the internal circumference of the ditch 12c. The shape and the number of the ditch is not restricted to a certain condition. The cross section of the modification shown in FIG. 3 corresponds to the present embodiment shown in FIG. 1 B.

However, the ditch 12c does not allow the gaseous body to escape from the inside space, thereby making it difficult to introduce the melted solder 30 in the inside space. Further, vacuuming the gaseous body increases complexity of the production facility and production cost. Furthermore, the gaseous body sealed in the inside space may deteriorate the reliability of connection by thermal-expansion and thermal-contraction.

On the contrary, the through hole 12b in the present embedment let the gaseous body out from the through hole 12b. In this manner, the solder 30 can be introduced to the internal circumference of the through hole 12b. This structure does not require any special facility. Therefore, the through hole 12b is more preferably as the opening on the bent portion 12a for contacting the circuit pattern 21 than the ditch 12c.

Further, the through hole 12b has a larger area of contact between the solder 30 and the outer lead 12 than the ditch 12c (the height of the fillet 30a is taller); thereby improving the reliability of connection.

### (Second embodiment)

Next, a second embodiment of the present invention is described with reference to FIGS. 4A and 4B. FIGS. 4A and 4B show connection structure of the electronic component 10 in the present embodiment, and FIG. 4A shows a cross section of the connection structure, and FIG. 4B shows a cross section of the outer lead taken along the IVB - IVB line. FIG. 4A corresponds to FIG. 1B.

The electronic component 10 in the second embodiment has a common part with the one described in the first embodiment. Therefore, the description of the common part is omitted, and the difference of the structure is mainly described.

As shown in FIG. 4A, the electronic component 10 in the present embodiment is characterized by a projection 12d protruding from the outer lead 12 instead of the through hole 12b or the ditch 12c as the opening in the connecting portion of the outer lead 12. The projection 12d is used to define a predetermined space between the outer lead 12 and the circuit pattern 21 in the connected condition.

The electronic component 10 in the present embodiment has the outer lead 12 extending from the package 11 bended in a predetermined shape for use as a connection portion. The bent portion 12a is substantially parallel with the circuit pattern 21 in the connected condition. The bent portion 12a has the projection 12d formed thereon.

The projection 12d is integrally formed with the outer lead 12 (bent portion 12a). In the present embodiment, a board made of, for example, cupper is cut in a certain shape to have a portion for the projection 12d bended substantially perpendicularly against the main body of the board as shown in FIGS 4A and 4B. The bonding portion 12a has the projections 12d on both sides as shown in FIG. 4B. In this manner, the electronic component 10 is stably placed on the printed circuit board 20 when the position of the electronic component 10 is determined before connection. However, the outer lead may have the projection 12d only on one side for the stable placement depending on the arrangement of the outer leads 12. In the present embodiment, the tip of the projection 12d is rounded so that the space between the bent portion 12a of the outer lead 12 and the circuit pattern 21 is substantially the same even in the case that the placement of the electronic component 10 is slid.

The connection structure of the electronic component 10 is described with reference to FIG. 4A.

As described in the first embodiment, the circuit pattern 21 on the printed circuit board 20 has the solder 30 as the connecting member pasted thereon by, for example, a screen printing in a portion that receives the bent portion 12a of the outer lead 12.

Then, the outer lead 12 and the circuit pattern 21 are connected with the solder 30 that is melted by abutting a press-heating tool (not shown in the figure) to the upper side of the outer lead 12 when the electronic component 10 is positioned on the printed circuit board 20 so that the tip of the projection 12d of the bent portion 12a contacts the solder 30.

The space between the outer lead 12 of the electronic component 10 and the circuit pattern 21 is kept in a predetermined distance defined by the height of the projection 12d when the projection 12d on the bent portion 12a of the outer lead 12 abuttingly contacts the circuit pattern 21 on the printed circuit board 20 in the present embodiment. Therefore, the variation of the thickness of the solder 30 between the outer lead 12 and the circuit pattern 21 or the height of the fillet 30a is decreased for a stabilized connection condition.

The projection 12d may be formed in a different manner from the one that is integrally formed with the outer lead 12 as a single plate to be processed in bending. That is, a separate part may be made of a heat-resistant material and may be attached to the bent portion 12a of the outer lead 12.

Although the present invention has been fully described in connection with the preferred embodiment thereof, it is to be noted that various changes and modifications will become apparent to those skilled in the art.

For example, the connecting member is described as the solder 30 in the present embodiment. However, the connecting member may be any material that melts by an application of heat and connects the outer lead 12 and the circuit pattern 21 after solidification

## Claims

1. A surface-mounted electronic component (10) comprising:
a body (11); and
an outer lead (12) extending from the body (11) for connection to a circuit pattern (21) on a printed circuit board (20) by using a connecting member (30) comprising,
wherein a hole (12b) having an opening at least on a connecting member facing side in a portion (12a) of the outer lead (12) for connecting the outer lead (12) to the circuit pattern (21).

2. The surface-mounted electronic component (10) according to claim 1,
wherein the outer lead (12) has a portion (12a) being held substantially parallel to the circuit pattern (21) in a connectively coupling condition of the outer lead (12) and the circuit pattern (21), and
the portion (12a) has the opening of the hole (12b).

3. The surface-mounted electronic component (10) according to claim 2,
wherein the hole (12b) pierces the outer lead (12).

4. The surface-mounted electronic component (10) according to claim 3,
wherein the connecting member (30) piercingly fills the hole (12b) of the outer lead (12), and
the connecting member (30) contacts a periphery of the hole (12b) on an opposite side of the circuit pattern facing side of the outer lead (12).

5. An electronic component (10) having an outer lead (12) extending from a package (11) for connection to a circuit pattern (21) on a printed circuit board (20) by using a connecting member (30) comprising:
a projection (12d) on the outer lead (12),
wherein the projection (12d) on the outer lead (12) is disposed in a portion (12a) of the outer lead (12) for connecting the outer lead (12) to the circuit pattern (21), and
the projection (12d) defines a predetermined amount of space between the outer lead (12) and the circuit pattern (21) when the outer lead (12) is connectively held with the circuit pattern (21).

6. The electronic component (10) according to claim 5,
wherein the outer lead (12) has a portion (12a) being held substantially parallel to the circuit pattern (21) in a connectively coupling condition of the outer lead (12) and the circuit pattern (21), and
the portion (12a) has the projection (12d).

7. The electronic component (10) according to any one of claims 1 to 6,
wherein the connecting member (30) is a solder.
